(19) Europäisches Patentamt
European Patent Office
Office européen des brevets

(11) EP 3 835 798 A1

(12) EUROPEAN PATENT APPLICATION

(43) Date of publication:
16.06.2021 Bulletin 2021/24

(51) Int Cl.:
G01R 27/02 (2006.01)　　　G01R 27/16 (2006.01)

(21) Application number: 19425088.2

(22) Date of filing: 12.12.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
KH MA MD TN

(71) Applicant: HT Italia S.r.l.
48018 Faenza RA (IT)

(72) Inventor: Mazzoni, Enrico
48018 Faenza RA (IT)

(74) Representative: Modiano, Micaela Nadia et al
Modiano & Partners
Via Meravigli, 16
20123 Milano (IT)

(54) **METHOD AND APPARATUS FOR MEASURING THE IMPEDANCE OF THE FAULT LOOP**

(57) A method for measuring the impedance of the fault loop, which is executed in conformity with the voltage drop method illustrated in the IEC 60364-6 standard, which consists of connecting a voltmeter to the terminals (A, B) of the circuit (C) to be subjected to verification, reading the voltage at the terminals (A, B) of the unpowered circuit (C), introducing a sinusoidal measurement current into the mains, with a measurement frequency comprised between 100 Hz and 120 Hz and a predefined intensity, reading the voltage at the terminals (A, B) of the circuit (C) while the measurement current is flowing, reading the voltage drop at the measurement frequency, filtering the voltages read by the voltmeter according to frequency, and calculating the impedance of the fault loop as a ratio of the voltage drop to the measurement frequency and the measurement current.

Fig. 1

**Description**

The present invention relates to a method and an apparatus for measuring the impedance of the fault loop.

The fault loop comprises the portion of circuit that starts at the user, arrives at the source by passing through the protective conductor and, by way of the active conductor, returns to the user.

Measuring the impedance of the fault loop serves to verify the correct operation of the systems for protection against indirect contacts. The purpose is to verify that, in the event of a dead short to earth, one that is such as to place the masses of the plant under voltage (entailing a danger to people's health), the current that is established is sufficiently high. In this manner, the magnetic protections intervene rapidly on the phase conductors and the power supply is automatically cut off.

For the fault current to have an adequate value, the impedance offered by the fault loop must be sufficiently low, i.e. observing safety rules and the associated values laid down by the regulations in force.

Protection of an electrical system against indirect contacts is increasingly often linked to the presence of devices called "residual current circuit breakers", which are designed to break the circuit if a differential magnetic flux is established in the electromagnet contained inside them.

The aforementioned electromagnet is in fact passed through by the active conductors (phases and neutral) and is therefore continuously subject to a magnetic flux given by the vectorial sum of the individual fluxes associated with the individual wires that pass through it: the electromagnet therefore produces an output signal (magnetic flux) that is proportional to the aforementioned vectorial sum.

If current is not dispersed to earth, the vectorial sum of the magnetic fluxes is nil and therefore the output signal from the electromagnet is also nil.

A current dispersed on the protective conductor and/or to earth does not pass through the electromagnet (because it flows through a different conductor than the phases and the neutral that intercept the electromagnet), therefore the vectorial sum of the fluxes and the corresponding output signal from the electromagnet will no longer be nil and as a consequence, when a preset threshold is exceeded, the tripping circuit will be activated, breaking the circuit and isolating the fault.

The value of the tripping current is typically equal to half of the rated response current of the residual current circuit breaker, and can vary from a few mA to 1 A.

The use of the above mentioned residual current protection device is spreading rapidly to TN distribution systems, supplanting the use of magneto-thermal switches or of fuses which intervene in case of currents of the order of tens of amperes or higher.

Although it is common practice to use residual current protection devices to ensure the safety of electrical systems, the regulations still require, in order to verify the protection against indirect contacts, the execution of high-resolution measurement (at least 0.01 Ohm) of the impedance of the fault loop and the calculation of the presumed corresponding short-circuit current to earth (such measurements and calculations lose their significance when we consider that the protection used is the residual current type).

Considering one phase at a time, the value of the impedance of the fault loop $Z_{LPE}$ is given by the vectorial sum $Z_{LPE} = Z_L + Z_{PE}$.

To execute the measurement of the impedance $Z_{LPE}$, it is common to use the method described by the IEC 60364-6 standard as the "voltage drop method": such method ensures a good level of precision as long as the "transient", i.e. the unpredictable fluctuation of the voltage Vo during the measurement, is negligible with respect to the "useful signal" i.e. the $\Delta V$ value introduced by the flow of current $I^{load}$ on Z.

Experience indicates that fluctuations of Vo can be of the order of a few mV and therefore, in order to operate with acceptable levels of uncertainty, $\Delta V$ must be at least 100 times higher i.e. of the order of one tenth of a volt.

Therefore the value of the test current, which is necessary to measure the impedance Z (which is of the order of 10 mOhm) with a good level of precision, must be higher than 10 A, a value that is incompatible with the response threshold of a residual current protection device, which is typically equal to 0.03 A.

The aim of the present invention is to solve the above mentioned drawbacks, by providing a method for measuring the impedance of the fault loop that is intrinsically precise, and which therefore is not influenced by fluctuations in the mains voltage.

Within this aim, an object of the invention is to provide a method for measuring the impedance of the fault loop that does not cause the tripping of residual current protection devices.

Another object of the invention is to provide an apparatus for measuring the impedance of the fault loop that is simple to use.

Another object of the present invention is to provide a method and an apparatus for measuring the impedance of the fault loop which are of low cost, easily and practically implemented and safe in use.

This aim and these and other objects which will become better apparent hereinafter are all achieved by a method for measuring the impedance of the fault loop, which is executed in conformity with the voltage drop method illustrated in the IEC 60364-6 standard, which consists of:

- connecting a voltmeter to the terminals of the circuit to be subjected to verification;
- reading the voltage at the terminals of the unpowered circuit;
- introducing a sinusoidal measurement current into the mains, with a measurement frequency comprised between 100 Hz and 120 Hz and a predefined intensity;

- reading the voltage at the terminals of the circuit while the measurement current is flowing;
- reading the voltage drop at the measurement frequency, filtering the voltages read by the voltmeter according to frequency,
- calculating the impedance of the fault loop as a ratio of the voltage drop to the measurement frequency and the measurement current.

Such aim and such objects are also achieved by an apparatus for measuring the impedance of the fault loop, of the type comprising a box-like body provided with at least one unit for measuring voltage of the type of a voltmeter and the like and at least one device for dispensing a current which is arranged in parallel with said unit along a branch which is controlled by a switching and regulating element of the electrical continuity, characterized in that it comprises:

- an actuation element for actuating said switching and regulating element of the electrical continuity, for regulating the intensity and frequency of the measurement current;
- at least one filtering stage for filtering the voltage at the terminals of the said unit for measuring voltage;
- at least one analog to digital conversion block for converting the signal in output from the said filtering stage;
- at least one computer for measuring the signal in output from the said conversion block;
- at least one interface element for the user, of the type of a display, a screen, a printer, a station for transmitting a signal to a remote apparatus and the like.

Further characteristics and advantages of the invention will become better apparent from the detailed description that follows of a preferred, but not exclusive, embodiment of the method and of the apparatus for measuring the impedance of the fault loop according to the invention, illustrated by way of non-limiting example in the accompanying drawing wherein:

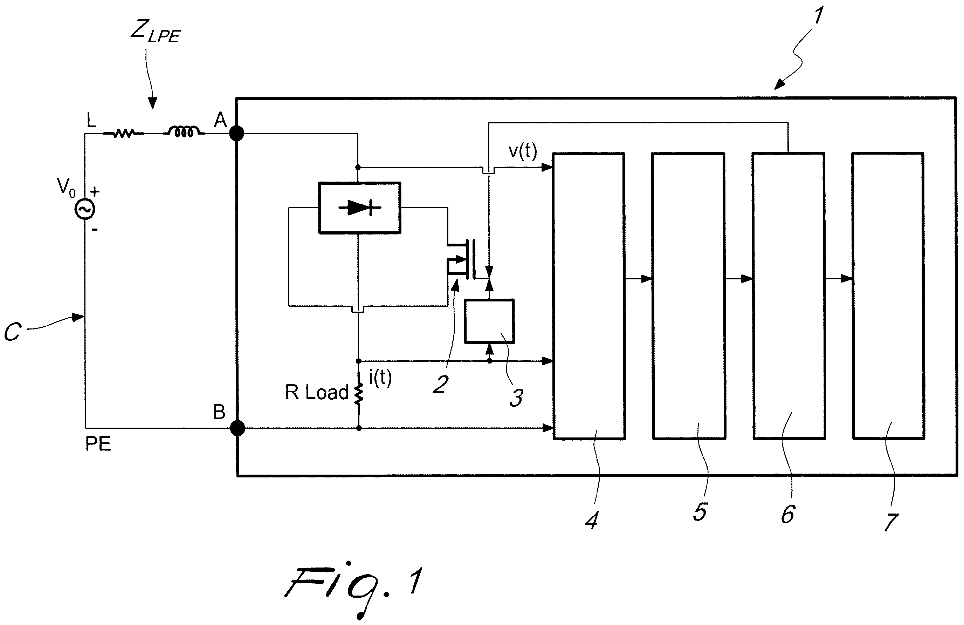

Figure 1 is a schematic view of a possible version of an apparatus for measuring the impedance of the fault loop according to the invention.

With particular reference to the figure, the reference numeral 1 generally designates an apparatus for measuring the impedance of the fault loop $Z_{LPE}$ (more correctly, of the value of the impedance of the fault loop $Z_{LPE}$).

The method according to the invention entails executing the measurement of the impedance of the fault loop $Z_{LPE}$ in conformity with the voltage drop method illustrated in the IEC 60364-6 standard.

According to the invention, in particular, it will be necessary to connect a voltmeter to the terminals A, B of the circuit C to be subjected to verification: it should be noted that the preferred solution entails connecting an apparatus 1 that comprises, inside it, the voltmeter and further instruments for measurement, as well as associated processors, memory components and interface means that make it possible to execute a plurality of diverse measurements. Multimeters or testers belong to this particular type of instruments.

Once the connection has been made it will be possible to carry out the reading of the voltage at the terminals of the unpowered circuit C (i.e. when no current is circulating in it).

Then a sinusoidal measurement current needs to be introduced into the mains (into the circuit C), with a measurement frequency comprised between 100 Hz and 120 Hz and a predefined intensity.

Then it will be possible to read, through the voltmeter (in particular with the apparatus 1) the voltage at the terminals (A, B) of the circuit (C) while the measurement current is flowing.

Once the two voltage values are known (the value read unpowered and the value read during circulation of the measurement current) we can read the voltage drop at the measurement frequency, filtering the voltages read by the voltmeter according to frequency.

Once this parameter has been obtained, it will be possible to calculate the impedance of the fault loop $Z_{LPE}$ as a ratio of the voltage drop to the measurement frequency and the measurement current.

It should be noted that, by way of the method according to the invention, it will furthermore be possible to have a subsequent step of calculating the short-circuit current, with the mains voltage and the impedance of the fault loop $Z_{LPE}$ being known, according to the formulas indicated in the IEC 60364-6 standard.

It should be noted that, according to the invention, the measurement current will advantageously have an intensity not greater than the tripping current of the residual current circuit breaker installed in the circuit C to be subjected to verification.

More specifically it should be noted that in an embodiment of undoubted practical and applicative interest, conveniently the sinusoidal measurement current has a frequency comprised between 105 Hz and 115 Hz and an intensity not higher than 0.03 A.

The quantity V(t), i.e. the voltage between the input terminals A and B of the measurement apparatus 1, can be expressed as follows:

$$v(t) = V_o \times \left[1 + k(t)\right] \times \sin(\omega_0 t)$$

where

ω<sub>0</sub> = 2πf<sub>0</sub> (f<sub>0</sub> mains frequency)

$\omega_0 = 2\pi f_0$ ($f_0$ mains frequency)
$k(t)$ accounts for the variation in unpredictable amplitude of the mains voltage.

The measurement current is found from an instantaneous modulation of the current by way of a modulation rule m(t), therefore the quantity i(t) becomes:

$$i(t) = I_o \times \left[1 + m(t)\right] \times \sin(\omega_0 t$$

where, expressing the modulation rule in a Fourier series:

$$m(t) = \left[ M_0 \times \sin(\omega_1 t) + \sum_{h=2}^{\infty} M_k \times \sin(\omega_h t + \varphi_h) \right]$$

and substituting it in the relation of i(t):

$$i(t) = I_o \times \left[ 1 + M_0 \times \sin(\omega_1 t) + \sum_{h=2}^{\infty} M_k \times \sin(\omega_h t + \varphi_h) \right] \times \sin(\omega_0 t)$$

$$= I_0 \times \sin(\omega_0 t) + I_0 \times M_0 \times \sin(\omega_1 t) \times \sin(\omega_0 t) +$$

$$+ I_o \times \left[ \sum_{h=2}^{\infty} M_k \times \sin(\omega_h t + \varphi_h) \right] \times \sin(\omega_0 t)$$

recalling the Werner formulas:

$$\sin\alpha \times \sin\beta = \frac{\cos(\alpha - \beta) - \cos(\alpha + \beta)}{2}$$

and applying it to the second term of the expression of i(t) we get:

$$i(t) = I_0 \times \sin(\omega_0 t) + I_0 \times M_0 \times \frac{\cos\left[(\omega_1 - \omega_0)t\right] - \cos\left[(\omega_1 + \omega_0)t\right]}{2} +$$

$$+ I_o \times \left[\sum_{h=2}^{\infty} M_k \times \sin(\omega_h t + \varphi_h)\right] \times \sin(\omega_0 t)$$

where:

$$G_0 = \frac{I_0 \times M_0}{2}$$

known constant

Therefore in the current i(t), acting on m(t), as well as at the "fundamental" pulsation term $\omega_0$ we can introduce:

- a frequency term $(\omega_1 - \omega_0)$
- a frequency term $(\omega_1 + \omega_0)$
- a sum of other high frequency terms $HF_I(t)$.

The current i(t) also circulates through the line impedance, therefore a corresponding number of terms will also be found in the voltage drop at the terminals of the line impedance.

The voltage V(t) measured at the terminals of the apparatus 1 can be expressed thus:

$$v(t) = V_o \times \left[1 + k(t)\right] \times \sin(\omega_0 t) - Z \times i(t)$$

$$v(t) = V_o \times \left[1 + k(t)\right] \times \sin(\omega_0 t) - Z \times \left\{I_0 \times \sin(\omega_0 t) + G_0 \times \cos\left[(\omega_1 - \omega_0)t\right] - G_0 \times \cos\left[(\omega_1 + \omega_0)t\right] + HF_I(t)\right\}$$

$$v(t) = V_o \times \left[1 + k(t)\right] \times \sin(\omega_0 t)$$
$$- Z \times I_0 \times \sin(\omega_0 t)$$
$$- Z \times G_0 \times \cos\left[(\omega_1 - \omega_0)t\right]$$
$$- Z \times G_0 \times \cos\left[(\omega_1 + \omega_0)t\right]$$
$$- Z \times HF_I(t)$$

Therefore, in the voltage V(t), in addition to the "fundamental" pulsation terms $\omega_0$, there are also:

- a frequency term $(\omega_1 - \omega_0)$ proportional to Z and not bound to k(t);
- a frequency term $(\omega_1 + \omega_0)$ proportional to Z and not bound to k(t);
- a sum of other high frequency terms $HF_I(t)$.

So, using a selective voltmeter (the apparatus 1), isolating only the sun pulsation components $(\omega_1 - \omega_0)$ or $(\omega_1 + \omega_0)$ we can carry out the measurement of Z uninfluenced by the unpredictable variations of the voltage k(t) which have pulsation $\omega_0$.

By conveniently selecting the value of $\omega_1$ we can make $(\omega_1 - \omega_0)$ or $(\omega_1 + \omega_0)$ fall in a particularly favorable frequency range, where transients on the electricity grids are typically negligible.

In particular it is known that, in electricity grids, the low-order and equal harmonics have a very low value.

Therefore in the present invention the deliberate choice was made of a frequency of 109 Hz which falls in the frequency range comprised between the second harmonics of 50Hz and 60Hz.

It should be noted that, according to a embodiment of discretionary implementation, of undoubted practical and applicative interest, the method according to the invention can advantageously comprise an optional step of introducing a second sinusoidal measurement current, with a second measurement frequency comprised between 0 Hz and 20 Hz and a predefined intensity.

In such case it will therefore be necessary to carry out the reading of the voltage at the terminals A, B of the circuit C while the second measurement current is flowing and therefore the reading of the voltage drop at the second measurement frequency (the reading of the voltage at the unpowered terminals A, B has already been carried out previously, before introducing the first measurement current and the second measurement current, which happen in subsequent steps), filtering the voltages read by the voltmeter according to frequency.

Based on the voltage drop value calculated using the values read while the second measurement current is flowing, it will then be possible to proceed to calculate the value of the impedance of the fault loop at the second frequency as a ratio of the voltage drop to the second measurement frequency and the second measurement current.

It will therefore be possible to compare and identify an average value between the value of the impedance of the fault loop $Z_{LPE}$ at the first frequency and the value of the impedance of the fault loop at the second frequency: this operating method will make it possible to achieve a level of precision that is even higher than the precision obtainable via the reading carried out using the circulation of the first measurement current alone.

The present invention also extends its protection to include an apparatus 1 for measuring the impedance of the fault loop $Z_{LPE}$ which comprises a box-like body provided with at least one unit for measuring voltage of the type of a voltmeter and the like and at least one device for dispensing a current which is arranged in parallel with the unit along a branch which is controlled by an element for switching and regulating 2 electrical continuity.

The apparatus 1 comprises an actuation element 3 for actuating the switching and regulating element 2 of the electrical continuity, for regulating the intensity and frequency of the measurement current.

The apparatus 1 further comprises at least one filtering stage for filtering the voltage at its terminals A, B.

In particular the voltage filtering stage can conveniently comprise a hardware filtering network 4 and subsequent filtering via software, i.e. digital processing of the signal, downstream of an analog to digital converter 5.

Downstream of the converter 5 there will positively be at least one computer 6 for measuring the signal v(t) at its inputs: the computer 6 (generally constituted by a microprocessor) will furthermore handle the conversion of the signal at its inputs, by way of adapted calibration coefficients, to the value of the sought impedance $Z_{LPE}$.

By way of at least one interface element 7 for the user, which can conveniently be selected from displays, screens, printers, stations for transmitting signals to a remote apparatus and the like, it will be possible to display the impedance value read so as to make such value available to the operator.

It should be noted that it will furthermore be possible to display the corresponding value of the presumed short-circuit current on the interface element as well.

Obviously, the apparatus 1 according to the invention will positively comprise a pair of terminals A, B (generally provided with connecting cables which are provided with respective clamps) for connecting the circuit C to be subjected to reading, so as to make it possible to easily measure the impedance of the fault loop $Z_{LN}$ between the phase conductor and the neutral conductor and also the impedance of the fault loop $Z_{LPE}$ between the phase conductor and the protective conductor (measurements carried out at different times).

According to a particular embodiment, the apparatus 1 can conveniently comprise three terminal clamps for connecting to the circuit C to be subjected to reading: in such case it will be possible to measure the impedance of the fault loop $Z_{LN}$ between the phase conductor and the neutral conductor and the impedance of the fault loop $Z_{LPE}$ between the phase conductor and the protective conductor or ground conductor (with measurements that are substantially simultaneous).

Finally it should be noted that, from an implementation point of view, the switching and regulating element 2 of the electrical continuity is constituted by at least one component selected from BJT, MOSFET, IGBT, TRIAC, SCR and the like.

Advantageously the present invention solves the above mentioned problems, by providing a method for measuring the impedance of the fault loop $Z_{LPE}$ (but also $Z_{LN}$) that is intrinsically precise, therefore which is not influenced by fluctuations in the mains voltage, because of the fact that the readings can be carried out at a different frequency from that of the mains and from that of the corresponding harmonics.

Conveniently the method according to the invention does not cause the tripping of residual current protection devices, in that it makes it possible to perform extremely precise measurements of the impedance of the fault loop using measurement currents of low intensity, in particular of lower intensity than that required to trip residual current protection devices. By virtue of the different frequency of such measurement currents (with respect to the mains frequency and to the frequency of the corresponding harmonics) the transients induced by the fluctuation of the mains voltage do not have repercussions on the precision of the measurement.

Profitably the apparatus 1 for measuring the impedance of the fault loop $Z_{LPE}$ (but also $Z_{LN}$) is very simple to use.

Positively the method and the apparatus 1 for measuring the impedance of the fault loop $Z_{LPE}$ (but also $Z_{LN}$) are easily and practically implemented and of low cost: such characteristics make the method and the apparatus 1 according to the invention described up to this point innovations that are certain to be safe in use.

The invention, thus conceived, is susceptible of numerous modifications and variations, all of which are within the scope of the appended claims. Moreover, all the details may be substituted by other, technically equivalent elements.

In the embodiments illustrated, individual characteristics shown in relation to specific examples may in reality be interchanged with other, different characteristics, existing in other embodiments.

In practice, the materials employed, as well as the dimensions, may be any according to requirements and to the state of the art.

Where the technical features mentioned in any claim are followed by reference numerals and/or signs, those reference numerals and/or signs have been included for the sole purpose of increasing the intelligibility of the claims and accordingly, such reference numerals and/or signs do not have any limiting effect on the interpretation of each element identified by way of example by such reference numerals and/or signs.

**Claims**

1. A method for measuring the impedance of the fault loop, which is executed in conformity with the voltage drop method illustrated in the IEC 60364-6 standard, which consists of:

   - connecting a voltmeter to the terminals (A, B) of the circuit (C) to be subjected to verification;
   - reading the voltage at the terminals (A, B) of the unpowered circuit (C);
   - introducing a sinusoidal measurement current into the mains, with a measurement frequency comprised between 100 Hz and 120 Hz and a predefined intensity;
   - reading the voltage at the terminals (A, B) of the circuit (C) while the measurement current is flowing;
   - reading the voltage drop at the measurement frequency, filtering the voltages read by the voltmeter according to frequency,
   - calculating the impedance of the fault loop as a ratio of the voltage drop to the measurement frequency and the measurement current.

2. The method according to claim 1, **characterized in that** it entails a subsequent step of calculating the short-circuit current, with the mains voltage and the impedance of the fault loop being known, according to the formulas indicated in the IEC 60364-6 standard.

3. The method according to claim 1, **characterized in that** said measurement current has an intensity not greater than the tripping current of the residual current circuit breaker installed in the circuit (C) to be subjected to verification.

4. The method according to claim 1, **characterized in that** said sinusoidal measurement current has a frequency comprised between 105 Hz and 115 Hz and an intensity not higher than 0.03 A.

5. The method according to claim 1, **characterized in that** it comprises an optional step of:

   - introducing a second sinusoidal measurement current, with a second measurement frequency comprised between 0 Hz and 20 Hz and a predefined intensity;
   - reading the voltage at the terminals (A, B) of the circuit (C) while the second measurement current is flowing;
   - reading the voltage drop at the second measurement frequency, filtering the voltages read by the voltmeter according to frequency;
   - calculating the value of the impedance of the fault loop at the second frequency as a ratio of the voltage drop to the second measurement frequency and the second measurement current;
   - comparing and identifying an average value between the value of the impedance of the fault loop at the first frequency and the value of the impedance of the fault loop at the second frequency.

6. An apparatus for measuring the impedance of the fault loop, of the type comprising a box-like body provided with at least one unit for measuring voltage of the type of a voltmeter and the like and at least one device for dispensing a current which is arranged in parallel with said unit along a branch which is controlled by a switching and regulating element (2) of the electrical continuity, **characterized in that** it comprises:

- an actuation element (3) for actuating said switching and regulating element (2) of the electrical continuity, for regulating the intensity and frequency of the measurement current;
- at least one filtering stage (4) for filtering the voltage at the terminal clamps (A, B) of said unit for measuring voltage;
- at least one analog to digital conversion block (5) for converting the signal in output from said filtering stage (4);
- at least one computer (6) for measuring the signal in output from said conversion block (5);
- at least one interface element (7) for the user, of the type of a display, a screen, a printer, a station for transmitting a signal to a remote apparatus and the like.

7. The apparatus according to claim 6, **characterized in that** it comprises a pair of terminal clamps (A, B) for connection to the circuit (C) to be subjected to reading, for also measuring the impedance of the fault loop between the phase conductor and the neutral conductor.

8. The apparatus according to claim 1, **characterized in that** it comprises three terminal clamps for connection to the circuit (C) to be subjected to reading, for measuring the impedance of the fault loop between the phase conductor and the neutral conductor and the impedance of the fault loop between the phase conductor and the protective conductor or ground conductor.

9. The apparatus according to one or more of the previous claims, **characterized in that** said element for switching and regulating (2) electrical continuity is constituted by at least one component selected from BJT, MOSFET, IGBT, TRIAC, SCR and the like.

Fig.1

Europäisches
Patentamt

European
Patent Office

Office européen
des brevets

# EUROPEAN SEARCH REPORT

Application Number

EP 19 42 5088

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2015/018019 A1 (UNI TREND TECHNOLOGY CHINA LTD [CN]) 12 February 2015 (2015-02-12) * paragraph [0078] - paragraph [0119]; figures 7,8 * | 1-9 | INV. G01R27/02 G01R27/16 |
| X | EP 1 705 490 A1 (METREL MERILNA [SI]) 27 September 2006 (2006-09-27) | 1,6 | |
| A | * paragraph [0003] - paragraph [0010]; claim 3; figures 1,2 * | 2-5,7-9 | |
| X | CN 102 096 019 A (HONGQUAN HUANG) 15 June 2011 (2011-06-15) | 1,6 | |
| A | * claims 1-5; figures 1,2 * | 2-5,7-9 | |
| X | ROSKOSZ RYSZARD ET AL: "A Method of Earth Fault Loop Impedance Measurement without Unwanted Tripping of RCDs", 2018 PROGRESS IN APPLIED ELECTRICAL ENGINEERING (PAEE), IEEE, 18 June 2018 (2018-06-18), pages 1-4, XP033390763, DOI: 10.1109/PAEE.2018.8441050 [retrieved on 2018-08-20] | 1,6 | |
| A | * figures 1,3,4 * | 2-5,7-9 | |
| A | FAIFER M: "The Calibration of Loop Impedance Meters: a Proposal", INSTRUMENTATION AND MEASUREMENT TECHNOLOGY CONFERENCE, 2006. IMTC 2006. PROCEEDINGS OF THE IEEE; 24 APRIL 2006 - 27 APRIL 2006, PISCATAWAY, NJ, USA,IEEE, 1 January 2006 (2006-01-01), pages 1620-1625, XP031017151, ISBN: 978-0-7803-9360-8 * figures 1,3 * | 1-9 | |

TECHNICAL FIELDS SEARCHED (IPC)

G01R

-/--

The present search report has been drawn up for all claims

| Place of search | Date of completion of the search | Examiner |
|---|---|---|
| Munich | 8 June 2020 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 19 42 5088

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 108 957 140 A (CHINA ELECTRIC POWER RES INST CO LTD; STATE GRID CORP CHINA ET AL.) 7 December 2018 (2018-12-07) | 1,6 | |
| A | * claim 1; figure 1 * ----- | 2-5,7-9 | |
| A | AIGNER MARIA ET AL: "Fault loop impedance determination in low-voltage distribution systems with non-linear sources", IEEE PES ISGT EUROPE 2013, IEEE, 6 October 2013 (2013-10-06), pages 1-5, XP032549837, DOI: 10.1109/ISGTEUROPE.2013.6695481 [retrieved on 2013-12-24] * the whole document * ----- | 1-9 | |
| A | "Low voltage electrical installations - Part 6: Verification", IEC 60364-6:2016, IEC, 3, RUE DE VAREMBÉ, PO BOX 131, CH-1211 GENEVA 20, SWITZERLAND, 27 April 2016 (2016-04-27), pages 1-100, XP082003505, [retrieved on 2016-04-27] * the whole document * ----- | 1-9 | TECHNICAL FIELDS SEARCHED (IPC) |
| A | US 2003/156367 A1 (MACBETH BRUCE F [US]) 21 August 2003 (2003-08-21) * paragraph [0037] - paragraph [0045] * ----- | 1-9 | |

The present search report has been drawn up for all claims

| Place of search | Date of completion of the search | Examiner |
|---|---|---|
| Munich | 8 June 2020 | O'Callaghan, D |

page 2 of 2

## ANNEX TO THE EUROPEAN SEARCH REPORT
## ON EUROPEAN PATENT APPLICATION NO.

EP 19 42 5088

This annex lists the patent family members relating to the patent documents cited in the above-mentioned European search report.
The members are as contained in the European Patent Office EDP file on
The European Patent Office is in no way liable for these particulars which are merely given for the purpose of information.

08-06-2020

| Patent document cited in search report | | Publication date | Patent family member(s) | | Publication date |
|---|---|---|---|---|---|
| WO 2015018019 | A1 | 12-02-2015 | NONE | | |
| EP 1705490 | A1 | 27-09-2006 | AT | 465417 T | 15-05-2010 |
| | | | EP | 1705490 A1 | 27-09-2006 |
| | | | SI | 22025 A | 31-10-2006 |
| CN 102096019 | A | 15-06-2011 | NONE | | |
| CN 108957140 | A | 07-12-2018 | NONE | | |
| US 2003156367 | A1 | 21-08-2003 | NONE | | |

EPO FORM P0459

For more details about this annex : see Official Journal of the European Patent Office, No. 12/82